# EUROPEAN PATENT APPLICATION

(11) **EP 1 328 144 A1**
(43) Date of publication of application: **16.07.2003**
(21) Application number: 02000607.8
(22) Date of filing: 10.01.2002
(51) Int. Cl.: H05K 9/00, H05K 7/14

(54) **Memory heat sink device**

(71) Applicant: Wei, Wen-Chen, Taipei Hsien (TW)
(72) Inventor: Wei, Wen-Chen, Taipei Hsien (TW)
(74) Representative: Zeitler, Giselher (DE)

(57) **Abstract**

A memory heat sink device includes a heat sink piece and a clamp member, wherein a retaining portion is disposed at the upper end rim of the heat sink to assemble two heat sink pieces and to make a space on the inner side for receiving a memory; a position limiting slot is disposed on the outer lateral plane with a retainer hole at the upper end thereof for hooking a reverse hook of the clamp member; a guide hole is disposed at the upper end of the retaining hole; the upper end rim connects with the guide hole bends to form a bearing retainer seat; the clamp member placed across the bearing retainer seat clamps two heat sink pieces to press the opening end into the position limiting slot, thereby the reverse hook and the retainer hole are fixedly hooked to easily assemble a heat sink device.

## Description

### BACKGROUND OF THE INVENTION

### 1) FIELD OF THE INVENTION

The present invention of a memory heat sink device mainly provides the random access memory (RAM) with a heat sink device of simple structure and convenient assembly.

### 2) DESCRIPTION OF THE PRIOR ART

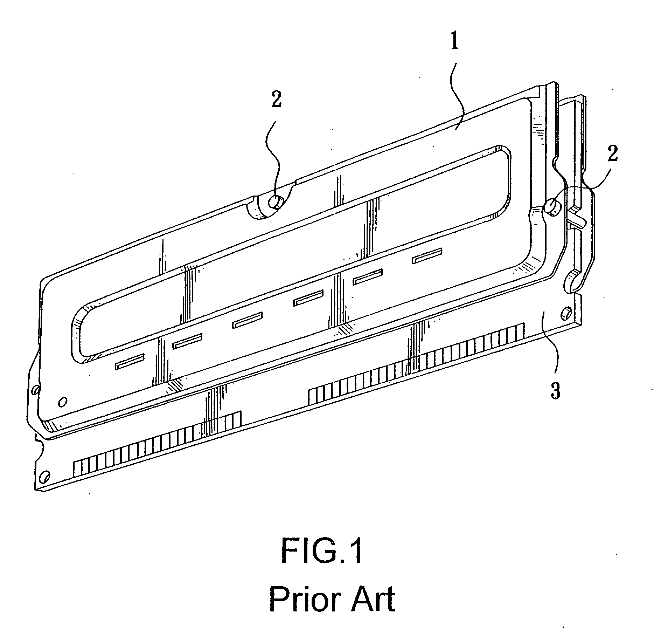

Accordingly, in order to solve the overheat problem of the internal heat generating components of the computer main set, the computer industrials usually install a heat sink device on the CPU, the IC components, the power chips, the power supplier, the memory, etc., to allow the high heat generated by the electronic components to be diffused through the heat sink device. However, the general assembled heat sink device for the memory, as shown in FIG. 1, has predetermined rivet hole disposed on the heat sink piece (1) with heat conducting film attached on the inner plane thereof; the memory (3) is clamped between two heat sink pieces (1) to be riveted by a rivet (2), thereby the heat generated in memory operation can be dissipated outwards through the heat sink pieces; however, this riveting method needs to stack up the heat sink piece and the memory first, then the rivets are aligned with the rivet holes for fixedly riveting; the assembling procedure is very complicated and inconvenient; furthermore, since the heat sink piece is thick and the space preset for receiving the memory usually occupies wider space, usually the heat sink piece is inserted to the insert slot on the outmost side for not influencing the other components; in addition, situations such as loosening and disengaging might happen during the assembling procedure, therefore, the undesired rate of this kind of heat sink structure tends to be high.

### SUMMARY OF THE INVENTION

The inventor of the present invention, addressed the shortcomings of the conventional heat sink device causing the inconvenience in assembling and not being practical, based on the engaged experience obtained from the engagement for many year, started to conducted the structural improvement towards the mentioned shortcomings. Specifically, the present invention mainly comprises two retainable heat sink pieces and a clamp member, wherein the said heat sink piece has a position limiting slot disposed on the outer lateral plane thereof, the said u-shaped convex position limiting slot projects on the surface of the piece body; the inner periphery forms a receiving space slightly wider than the clamp member for bearing and limiting the position of the clamp member; a retainer hole is disposed at the upper end of the position limiting slot for reversely retaining the reverse hook; a guiding hole is disposed at the upper end of the said retaining hole for facilitating the reverse hook to slide accordingly and insert into the retaining hole; the end connecting with the guide hole bends to form a bearing retainer seat; the central portion of the bearing retainer seat bends downwards to form a positioning piece; the said positioning piece is lower than the two lateral sides thereof and can be fitly clamped across by the clamp piece, thereby the crossing clamp member does not displace or move; a retaining portion is extended from the upper end rim of the heat sink piece; a retaining hook and a retaining hole are respectively disposed at proper positions on the said retaining member, thereby, two heat sink piece can be connected to define a space for receiving the memory; the inner lateral plane of the heat sink piece is attached by a heat conducting film for increasing the heat conducting efficiency of the memory; the said clamp member is an n-shaped clamp piece with a narrower opening end for forming a proper resilience; a reverse hook is disposed respectively on the two lateral sides of the clamp piece to reversely hook with the retainer hole for reducing the thickness of the plane member; when in assembling, the retaining portions of two heat sink pieces are retained first, then the memory is inserted in between, then the clamp member clamps two heat sink pieces to place the top portion of the clamp member across the positioning piece; the opening end thereof presses into the position limiting slot; at this time, the reverse hook and the retaining hole retain reversely for fastening; a heat sink device can be easily and simply assembled accordingly; since the width of the two lateral sides of the positioning piece corresponds to the width of the receiving space of the position limiting slot, the guide hole additionally facilitates the sliding and the alignment of the reverse hook; when in assembling, it is only necessary to align the reverse hook of the clamp member with the guide hole for an easy insertion to finish the clamping; not only the force exertion is easy, but the assembling operation is also very simple and convenient. Since the memory needs to be inserted into the insert slot and there are many insert slots disposed for inserting various electronic components, the design of the memory is required to be particularly light and thin for facilitating the insertion and preventing the influence or damage on the other electronic components; the present invention is of an unitarily molded piece, the whole structure is disposed towards the inner plane with light and thin specialty; only the position limiting slot on the outer lateral surface has slightly projecting thickness for receiving the clamp member to meet the mentioned need of the insert slot; more particularly, the present invention requires no tool at all to finish the assembling, the assembling is not only simple and fast, it is also very convenient.

Therefore, the primary objective of the present invention is to provide a memory heat sink device by disposing a retaining portion on an unitarily molded heat sink piece to retain and assemble the heat sink pieces; a position limiting slot with an u-shaped convex plane is disposed on the outer lateral plane of the piece body to make the inner periphery thereof to form a receiving space to fitly bear the clamp member for retaining and fastening thereby to assemble a light and thin heat sink device.

Another objective of the present invention is to provide a memory heat sink device by using the reverse hook with two lateral sides bent inwardly on the clamp member, the retaining hole disposed at the upper end of the position limiting slot and the guiding of the guide hole to facilitate the reverse hook to slide and insert correspondingly into the retaining hole to form a fixedly reverse retaining as well as a simple and fast assembling.

Yet another objective of the present invention is to provide a memory heat sink device with disposed members requiring no tool at all to finish assembling in a very convenient way.

To enable a further understanding of the specific features and structure, the brief description of the drawings below is followed by the detailed description of the preferred embodiment.

### BRIEF DESCRIPTION OF THE DRAWINGS

Figure 1 is a pictorial drawing of a conventional heat sink device.
Figure 2 is an exploded drawing of the members of the present invention.
Figure 3 is a schematic drawing of the assembled present invention.

### DETAILED DESCRIPTION OF THE PREFERRED EMBODIMENTS

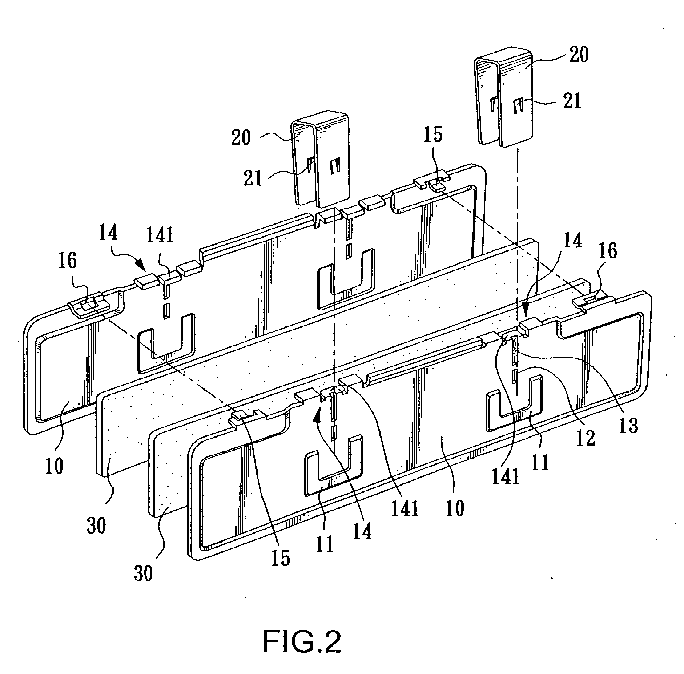

Referring to FIG. 2, the exploded drawing of the members of the present invention, the present invention comprises a heat sink piece (10), a clamp member (20) and a heat conducting film (30), wherein the said heat sink piece (10) has a convex u-shaped position limiting slot (11) disposed thereon and projecting on the surface of the piece body; the inner periphery thereof forms a receiving space; a retaining hole (12) is disposed at the upper end of the position limiting slot (11) for reversely retaining the reverse hook (21); a guiding hole (13) is disposed at the upper end of the said retaining hole (12) for facilitating the reverse hook (21) to slide accordingly and insert into the retaining hole (12); the end connecting with the guide hole bends to form a bearing retainer seat (14); the central portion of the said bearing retainer seat (14) bends downwards to form a positioning piece (14) which is lower than the two lateral sides thereof and can be fitly clamped across by a clamp piece (20) to prevent displacing or moving; a retaining portion is disposed at a proper position on the upper end rim of the heat sink piece (10) and has respectively a retaining hook (15) and a retaining hole (16) for connecting two heat sink pieces (10); the said clamp member (20) is an n-shaped clamp piece with a opening end narrower than the top end thereof for forming a proper resilience during retaining; an inward reverse hook (21) is disposed respectively on the two lateral sides of the clamp piece (20) with a thickness corresponding to that of the position limiting slot (21) for reducing the thickness of the planes of the members; the inner lateral plane of the heat sink piece (10) is attached by the said heat conducting film (30) for fast and evenly conducting the heat generated during the memory operation to the heat sink pieces (10) for dissipating.

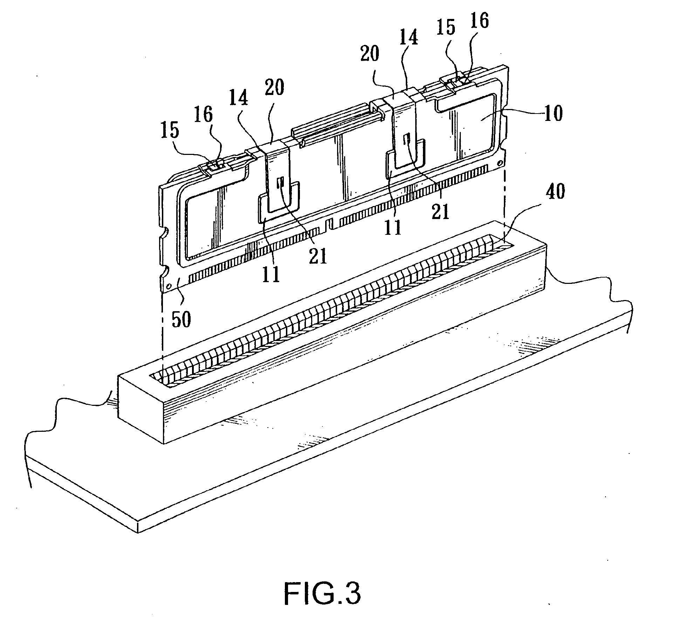

Referring to FIG. 3, schematic drawing of the assembled present invention, when the heat conducting films (30) are respectively attached to the inner sides of the heat sink pieces (10), the retaining hook (15) and the retaining hole (16) at the top end of two heat sink pieces (10) are retained first, then the memory (50) is inserted inside and clamped by the clamp member (20) placed across the bearing retainer seat (14); the top portion thereof is fixedly mounted on the positioning piece (141); since the positioning piece (141) is lower than the two lateral sides thereof, the clamp member (20) does not tend to displace or move but slides downwards according to the guide hole (13) to make the opening end press into the position limiting slot (11) and to make the reverse hook (21) reversely retaining the retaining hole (12) for firmly attaching and assembling the heat sink pieces (10) and the memory (50); accordingly, the memory (50) is inserted into the insert slot (40) and the heat is diffused through the heat sink pieces (10).

All of the members of the present invention are disposed on the heat sink piece (10) bodies and the inner planes thereof, only the thickness of the convex plane of the position limiting slot (21) is provided for receiving the clamp member (20), therefore, the present invention has the thinnest specialty; additionally, it requires no tool for assembling and is very convenient and practical.

It is of course to be understood that the embodiment described herein is merely illustrative of the principles of the invention and that a wide variety of modifications thereto may be effected by persons skilled in the art without departing from the spirit and scope of the invention as set forth in the following claims.

## Claims

1. A memory heat sink device mainly comprises a heat sink piece, a clamp member and a heat conducting film, wherein a retaining hook and a retaining hole are disposed respectively in a proper area at the upper end rim of the heat sink piece to assemble two heat sink pieces and to define a space on the inner side for receiving a memory; the inner lateral plane of the heat sink piece is attached by the said heat conducting film for fast and evenly conducting the heat generated during the memory operation to the heat sink pieces for dissipating; the present inventin is **characterized that**:
the said heat sink piece has a position limiting slot disposed on the outer lateral plane thereof, the said u-shaped convex position slot projects on the surface of the piece body to define the inner periphery a receiving space slightly wider than the clamp member to be pressed against; a retainer hole is disposed at the upper end of the position limiting slot for reversely retaining the reverse hook; a guiding hole is disposed on the upper end of the said retaining hole for the reverse hook to slide accordingly and insert into the retaining hole; the upper rim connects with the guide hole bends to form a bearing retainer seat and the central portion thereof further bends downwards to form a positioning piece;
the said clamp member is an n-shaped clamp piece with a narrower opening end and reverse hooks are disposed inwardly on two lateral sides thereof; the said reverse hook reversely retains the said retaining hole for fastening; two heat sink pieces enclose the memory and are clamped by the clamp member placed across the bearing retainer seat for a firm attachment to achieve the efficiency of a simple structure and convenient assembly.
